Europäisches Patentamt

(19) European Patent Office

Office européen des brevets

(11) Publication number: **0 023 400**
**B1**

# EUROPEAN PATENT SPECIFICATION

(45) Date of publication of patent specification: **21.03.84**

(51) Int. Cl.³: **H 01 L 23/02, H 01 L 23/50**

(21) Application number: **80302341.5**

(22) Date of filing: **10.07.80**

(54) Leadless packages for semiconductor devices.

(30) Priority: **11.07.79 JP 95327/79**

(43) Date of publication of application:
**04.02.81 Bulletin 81/5**

(45) Publication of the grant of the patent:
**21.03.84 Bulletin 84/12**

(84) Designated Contracting States:
**DE FR GB NL**

(56) References cited:
**DE - A - 1 952 789**
**FR - A - 2 158 043**
**FR - A - 2 192 376**
**GB - A - 2 027 988**
**US - A - 3 801 881**

(73) Proprietor: **FUJITSU LIMITED**
**1015, Kamikodanaka Nakahara-ku**
**Kawasaki-shi Kanagawa 211 (JP)**

(72) Inventor: **Honda, Norio**
**21-4, Miyashita Kamiarakuda Machikitamachi**
**Aizuwakamatsu-shi Fukushima, 965 (JP)**
Inventor: **Hayashi, Kunihiko**
**6212-3-5-104, Izumi-cho Totsuka-ku**
**Yokohama-shi Kanagawa, 245 (JP)**

(74) Representative: **Bedggood, Guy Stuart et al,**
**Haseltine Lake & Co. Hazlitt House 28**
**Southampton Buildings Chancery Lane**
**London WC2A 1AT (GB)**

Leadless packages for semiconductor devices.

This invention relates to leadless packages for semiconductor devices.

Terminal leads on packages for semiconductor devices have been dispensed with as circuit integration density of integrated circuits (IC) and large scale integrated circuits (LSI) has increased, and as packing density with which components are mounted on printed substrates of a mother circuit board has increased. In place of packages with leads leadless packages provided with terminal pads on one or both major faces of the packages have been used extensively.

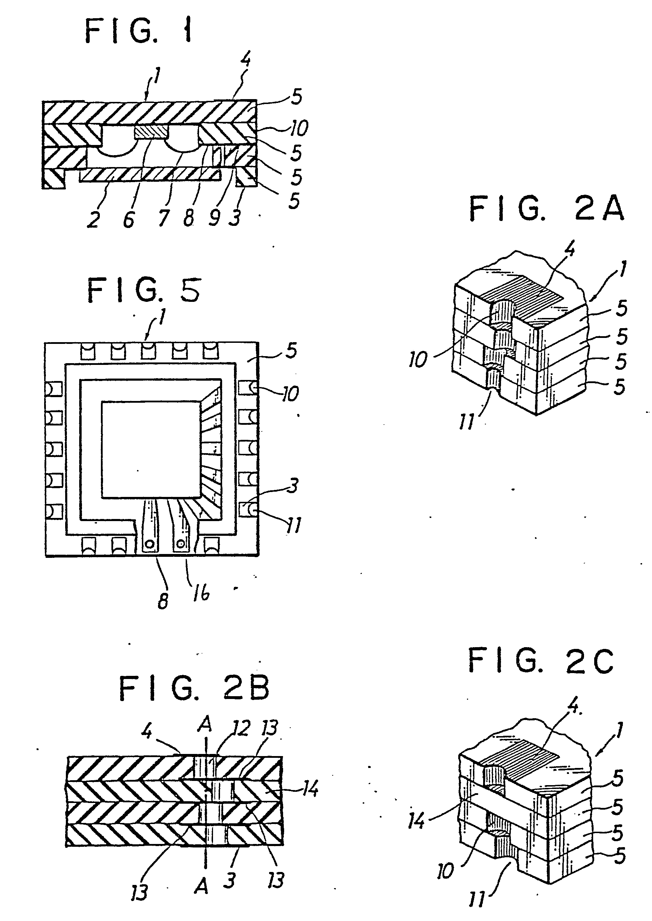

For assistance in understanding a defect which has been found in leadless packages, reference will first be made to Figure 1 of the accompanying drawings which shows schematically in cross-section the structure of one type of leadless package. Reference will also be made to Figures 2A, 2B and 2C of the accompanying drawings, of which Figure 2A is an isometric view illustrating a conductive path established in the package of Figure 1, Figure 2B is a cross-sectional view showing through holes provided in substrates which are used to make up the package of Figure 1, and Figure 2C is an isometric view similar to that of Figure 2A but illustrates a case in which there is a discontinuity in the conductive path.

In Figure 1 a leadless package 1 has a solder pads or terminal pads 3 provided to an edge of a major face of the package, to which a cap 2 is bonded, for soldering the package 1 to printed circuits of a mother board. Probe pads or terminal pads 4, each of which is, for example, approximately 0.4 mm wide (see Fig. 2A) and to each of which a probe may be abutted for the purpose of measurement and so forth, are provided to an edge of the other major face of the package. The pitch or distance between adjacent pads 4 is approximately 1.2 mm.

The leadless package as shown has a structure which provides terminal pads at the upper and lower faces of the package, with one set of pads used as solder pads 3 and the other as probe pads 4, but a leadless package having a structure with terminal pads only on one major face of the package could also be provided.

In either structure, each terminal pad of the package is connected to a bonding pad 8 through conductive layers 9 and 10. Bonding pad 8 is connected to a metal wire 7, of aluminum for example, leading from a circuit pad (not shown) of a semiconductor chip 6 bonded to the internal surface of a top (as seen in Figure 1) substrate of the package 1, which package is formed by laminating four ceramic substrates 5.

A conductive layer 9 is formed by applying a conductive paste to one surface of a ceramic substrate 5 and a conductive layer 10 is formed to a side of the package 1.

There are shown in Figure 2A parts on one side of the package 1 of Figure 1 which is provided with conductive layers 10. As seen in the isometric view of Figure 2A, a notch 11 is formed to the one side of each of the four substrates 5 making up the package 1. Each of conductive layers 10 is formed by applying a conductive paste to each notch 11, and a conductive path is formed to the conductive layers 10 from a bonding pad 8 by way of a conductive layer 9, and then to terminal pads 3 and 4 on both major faces of the package. The illustrated notches 11 in the substrates 5 are formed when the substrates are cut along a line bisecting through holes therein, as will be described below.

In order to make a leadless package of the structure of Figures 1 and 2A, connection pads 13 are printed on ceramic substrates 5, each of which is for example 0.45 mm thick, as illustrated in Figure 2B. The substrates are formed with through holes 12 each of which is 0.4 mm in diameter in the example illustrated in Figure 2B, which illustrates in cross-section four ceramic substrates having through holes 12. Then the ceramic substrates 5 are laminated together. Conductive paste is poured into through holes 12 so as to cover the internal surface of each hole, the substrates are then fired and cut off along the chain line A—A to produce individual packages 1 each having four sides of a length of 8.6 mm for example.

In laminating green or unfired substrates 5 each having a thickness of 0.45 mm, a certain amount of misalignment is almost inevitable with current technology due to the minute size of the substrates and the through holes therein. As a result, it can happen that a ceramic substrate is cut through where there is no through hole, as is the case of substrate 14 in Figure 2B.

The resulting structure is illustrated in the isometric view of Figure 2C wherein the substrate 14 is shown without a notch 11 and consequently without a conductive layer 10. Thus, it will be understood that there is a discontinuity in the conductive path running through the substrates, rendering the package 1 useless.

For the purpose of overcoming above described defect experienced with the structure of Figures 1 and 2A to 2C, a method of forming a conductive path by means of through holes and connecting pads has been developed.

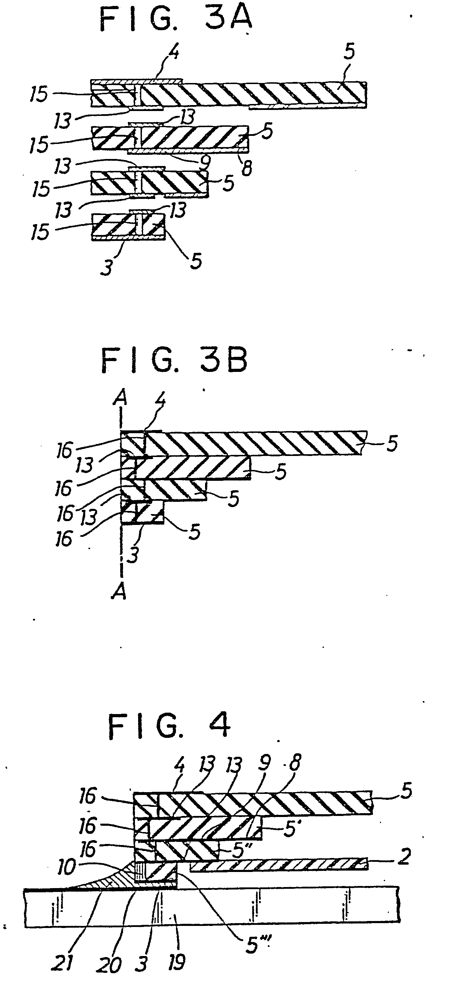

Reference will now be made to Figures 3A and 3B of the accompanying drawings, of which Fig. 3A is a cross-sectional exploded view illustrating the formation of through holes and connecting pads in substrates employed to form a semiconductor package pad, and Figure 3B is a cross-sectional view showing a conductive path formed in a package made up of substrates as shown in 3A.

According to this method, as shown in Figure 3A, through holes 15 are formed in respective ceramic substrates 5, and then the through holes 15 are filled with conductive paste. Connecting pads 13 are printed on the surfaces of the substrates 5 around the openings of the through holes 15, and further, bonding pads 8, conductive layers 9, solder pads or terminal pads 3 and probe pads or terminal pads 4 are also printed in a known manner. Thereafter, the ceramic substrates are piled or laminated together, and after firing, the substrates are cut along the line A—A as shown in Figure 3B to produce individual packages.

By virtue of such a structure, a bonding pad 8 is connected to terminal pads 3 and 4 through a conductive layer 9, conductive parts 16 of the through holes 15 and the connection pads 13 in the order described.

Comparing the structure of Figures 3A and 3B with the structure shown in Figures 2A, 2B and 2C it will be appreciated that the danger of a discontinuity appearing in the conductive path of the package due to a defect as shown in Figure 2C is avoided. However, with the structure of Figures 3A and 3B, if the package were soldered directly to a mother board, the connecting part between a solder pad 3 and the mother board would be hidden beneath the solder pad 3 and there would be a problem in that the state of connection could not be visually ascertained in the same way as in the structure of Figure 2A to 2C.

DE—A—1,952,789 discloses a package for a semiconductor device in which two ceramic substrates are laminated together. A conductive path from an internal bonding pad to the exterior of the package is provided by way of conductive parts on the internal surfaces of through holes in the substrates of the package and by way of conductive parts on the surfaces of substrates of the package. However, the package is provided with leads through which external connection is made. The state of solder connections between the leads and the package can be determined visually before the package is mounted on a mother board.

According to the present invention there is provided a leadless package for a semiconductor device, comprising a plurality of ceramic substrates laminated together, having a plurality of internal bonding pads on an internal surface of a ceramic substrate of the package, for connection to a semiconductor device mounted in the package, and a plurality of external terminal pads, on at least one major face of the package, wherein a plurality of conductive paths connecting the internal bonding pads with the external terminal pads are established by way of conductive parts on the internal surfaces of through holes provided in substrates of the package and by way of conductive parts on surfaces of substrates of the package, characterised in that the substrate having the external terminal pads thereon is provided at an edge thereof with a plurality of notches, each having a conductive layer on its surface, through which the said conductive paths are established, whereby the external terminal pads are directly soldered to a mother board when the package is mounted on the mother board.

A leadless package embodying this invention can be provided which is free from discontinuity in its conductive path and the connection of which to a mother board can be visually inspected to ascertain if the connection is good or not.

Briefly, in an embodiment of this invention a leadless package is formed by laminating a plurality of ceramic substrates so that the package has internal bonding pads and terminal pads on its major faces. A bonding pad and a terminal pad are connected by a conductive layer formed on the surface of a notch provided to one edge of the ceramic substrate having the terminal pad thereon, by the conductive parts of through holes arranged to run through other ceramic substrates, and by conductive layers provided on those substrates to make connection with the conductive parts of the through holes.

Reference is made, by way of example to the accompanying drawings, in which:—

Figure 1, as mentioned above, is a schematic cross-sectional view of the structure of a leadless package;

Figures 2A, 2B and 2C are respectively, as mentioned above, an isometric view illustrating a conductive path established in the package of Figure 1, a cross-sectional view of substrates used to make up the package of Figure 1, and an isometric view illustrating a discontinuity in the conductive path;

Figures 3A and 3B are respectively, as mentioned above, a cross-sectional exploded view illustrating the formation of through holes and connecting pads in substrates employed to form a semiconductor package, and a cross-sectional view of the package made up of the substrates of Figure 3A, showing a conductive path therein;

Figure 4 is a cross-sectional view showing a conductive path formed in a leadless package embodying the present invention;

Figure 5 is a view from below the package of Figure 4.

In Figure 4, there are shown three ceramic substrates 5, 5' and 5" which are no different in principle from the ceramic substrates shown in Figures 1 to 3. A conductive path is formed to run through the substrates up and down by means of conductive parts 16 of through holes formed in the substrates, and connecting pads 13 make connection with the conductive parts 16 and a conductive layer 9.

However, in Figure 4, the lowermost substrate 5''' is provided with a notch instead of a through hole. One end portion of a conductive layer 10 formed on the internal surface of the notch makes connection with a connecting pad 13 and the other end thereof makes connection with a terminal or solder pad 3.

The leadless package explained above is manufactured by a conventional process as follows: each of the ceramic substrates 5, 5′ and 5″ is formed with a predetermined through hole, and the substrate 5‴ with a through hole for subsequent making of a notch. Conductive paste is poured into the through hole, and the connecting pads, solder pads, probe pads, bonding pads and conductive layers are printed on the substrates. The ceramic substrates are laminated together and fired, and the cutting is effected through the line bisecting the through hole of the ceramic substrate 5‴ to produce individual packages.

Figure 5 is a view from below the leadless package formed as shown in Figure 4 with the chip, metal wire and cap 2 omitted.

Because of the manufacturing process carried out as has just been described, there is always a notch to one side of the substrate 5‴, so that there can be no discontinuity in the conductive path from the bonding pad 8 to the terminal pads 3 and 4.

Further, as shown in Figure 4, when the solder pads 3 are soldered to a printed circuit 20 on a mother board 19, solder 21 adheres also to the surface of conductive layer 10 on the surface of the notch and rise upwards as shown. Thus, there is a further advantage that it can be determined by visual inspection whether or not soldering has been performed in a satisfactory manner.

In the embodiment principle of the present invention of Figure 4, the notch 11 is provided on the lowermost substrate (i.e. the solder pad substrate) as seen in the Figure, but notches may be formed in the lowermost and in the uppermost substrates (i.e. in both terminal pad substrates).

As has been described, there can be no real danger of a defect as shown in Figure 2C causing discontinuity in the conductive path connecting the bonding pads and the terminal pads of the leadless package embodying the present invention. In addition, a solder joint made between the package and a mother board can be visually confirmed. Thus, product yield and the reliability of the semiconductor package are enhanced.

In an embodiment of this invention, a leadless package for a semiconductor device is formed by laminating a plurality of ceramic substrates. The package is provided with bonding pads internally and terminal pads on at least one major face thereof. A bonding pad and a terminal pad are connected by way of a conductive layer formed on the internal surface of a notch formed to one side of the ceramic substrate having the terminal pads thereon, and by way of conductive parts of through holes running through the other ceramic substrates and by way of conductive layers formed on those substrates which make connections with the conductive parts of the through holes.

A leadless semiconductor package embodying this invention is formed by a plurality of ceramic substrates laminated together. The package has an internal bonding pad and terminal pads on one or both major faces thereof. A ceramic substrate provided with a terminal pad is formed at one side thereof with a notch having a conductive layer on its surface. The other ceramic substrates are provided with through holes, having conductive parts on the internal surfaces thereof, which run through the substrates, and are provided with connecting pads on the surfaces of the substrates. The bonding pad and the terminal pad are connected by connecting pads, conductive parts of the through holes and the conductive layer on the surface of the notch.

## Claims

1. A leadless package for a semiconductor device, comprising a plurality of ceramic substrates laminated together, having a plurality of internal bonding pads on an internal surface of a ceramic substrate of the package, for connection to a semiconductor device mounted in the package, and a plurality of external terminal pads, on at least one major face of the package, wherein a plurality of conductive paths connecting the internal bonding pads with the external terminal pads are established by way of conductive parts on the internal surfaces of through holes provided in substrates of the package and by way of conductive parts on surfaces of substrates of the package, characterised in that the substrate having the external terminal pads thereon is provided at en edge thereof with a plurality of notches, each having a conductive layer on its surface, through which the said conductive paths are established, whereby the external terminal pads are directly soldered to a mother board when the package is mounted on the mother board.

2. A package as claimed in claim 1, having external terminal pads on respective major faces of the package, the said conductive paths connecting the internal bonding pads with respective external terminal pads on the respective major faces, wherein both major faces having terminal pads thereon are provided, at respective edges thereof, with respective pluralities of notches having conductive layers on their surfaces, through which the said conductive paths are established, whereby the external terminal pads are directly soldered to a mother board, when the package is mounted on the mother board.

3. A package as claimed in claim 1 or 2, wherein the said conductive parts on the surfaces of the substrates are provided by connecting pads on those surfaces.

## Patentansprüche

1. Leitungsloses Gehäuse für eine Halbleitervorrichtung, mit einer Mehrzahl von keramischen Substraten, welche zusammenlaminiert sind und, zur Verbindung mit einer in dem Gehäuse montierten Halbleitervorrichtung, eine Mehrzahl von inneren Verbindungsplättchen auf einer inneren Oberfläche eines keramischen Substrats des Gehäuses haben, und mit einer Mehrzahl von äußeren Anschlußplättchen auf wenigstens einer Hauptfläche des Gehäuses, bei welchem eine Mehrzahl von leitenden Wegen, welche die inneren Verbindungsplättchen mit den äußeren Verbindungsplättchen verbinden, durch leitende Teile auf den innerten Oberflächen von Durchgangslöchern gebildet sind, welche in den Substraten des Gehäuses vorgesehen sind, und durch leitende Teile auf Oberflächen von Substraten des Gehäuses, dadurch gekennzeichnet, daß das Substrat, auf welchem die äußeren Anschlußplättchen sind, an seinem Rand eine Mehrzahl von Ausnehmungen aufweist, welche jeweils eine leitende Schicht auf ihrer Oberfläche haben, durch welche die genannten leitenden Wege gebildet werden, wodurch die äußeren Anschlußplättchen direkt an die Mutterplatte angelötet werden, wenn das Gehäuse auf der Mutterplatte montiert wird.

2. Gehäuse nach Anspruch 1, mit äußeren Anschlußplättchen auf entsprechenden Hauptflächen des Gehäuses, bei welchem die genannten leitenden Wege die inneren Verbindungsplättchen mit entsprechenden äußeren Anschlußplättchen auf den entsprechenden Hauptflächen verbinden, wobei beide Hauptflächen, auf denen Anschlußplättchen sind, an ihren entsprechenden Rändern eine Mehrzahl von Ausnehmungen mit leitenden Schichten auf ihren Oberflächen aufweisen, durch welche die genannten leitenden Wege gebildet werden, wodurch die äußeren Anschlußplättchen direkt an die Mutterkarte angelötet werden, wenn das Gehäuse auf der Mutterkarte montiert wird.

3. Gehäuse nach Anspruch 1 oder 2, bei welchem die genannten leitenden Teile auf den Oberflächen des Substrates durch Verbindungsplättchen auf diesen Oberflächen gebildet sind.

## Revendications

1. Un boîtier sans conducteurs pour un dispositif semiconducteur comprenant un ensemble de substrats en céramique stratifiés ensemble, avec un ensemble de plots de fixation internes sur une surface interne d'un substrat en céramique du boîtier, pour la connexion à un dispositif semiconducteur monté dans le boîtier, et un ensemble de plots de bornes externes, sur au moins une face principale du boîtier, dans lequel un ensemble de chemins conducteurs connectant les plots de fixation internes aux plots de bornes externes sont établis au moyen d'élément conducteurs sur les surfaces internes de trous traversants formés dans des substrats du boîtier, et au moyen d'éléments conducteurs sur des surfaces de substrats du boîtier, caractérisé en ce que le substrat qui porte les plots de bornes externes comporte sur l'un de ses bords un ensemble d'encoches, chacune d'elles portant sur sa surface une couche conductrice par laquelle les chemins conducteurs sont établis, grâce à quoi les plots de bornes externes sont directement soudés sur une carte mère lorsqu'on monte le boîtier sur la carte mère.

2. Un boîtier selon la revendication 1, comportant des plots de bornes externes sur ses faces principales respectives, lesdits chemins conducteurs connectant les plots de fixation internes à des plots de bornes externes respectifs sur les faces principales respectives, dans lequel les deux faces principales comportant des plots de bornes sont munies, sur leurs bords respectifs, d'ensembles respectifs d'encoches ayant sur leur surface des couches conductrices par lesquelles les chemins conducteurs sont établis, grâce à quoi les plots de bornes externes sont directement soudés sur une carte mère, lorsque le boîtier est monté sur la carte mère.

3. Un boîtier selon la revendication 1 ou 2, dans lequel les éléments conducteurs sur les surfaces des substrats sont formés par des plots de connexion sur ses surfaces.

0 023 400

FIG. 1

FIG. 2A

FIG. 5

FIG. 2B

FIG. 2C

1

# F I G. 3A

# F I G. 3B

# F I G. 4